# EUROPÄISCHE PATENTSCHRIFT

(11) **EP 0 349 803 B1**
(45) Veröffentlichungstag und Bekanntmachung des Hinweises auf die Patenterteilung: **05.03.1997**
(21) Anmeldenummer: 89110912.6
(22) Anmeldetag: 16.06.1989
(51) Int. Cl.: G03F 7/004

(54) **Strahlungshärtbares Gemisch und daraus hergestelltes strahlungsempfindliches Aufzeichnungsmaterial für hochenergetische Strahlung**
Radiation-curable mixture and radiation-sensitive recording material prepared therefrom for highly energetic radiation
Mélange réticulable par radiation et matériel pour l'enregistrement sensible aux radiations de ce mélange pour un rayonnement hautement énergétique

(30) Priorität: 25.06.1988 DE 3821584
(43) Veröffentlichungstag der Anmeldung: 10.01.1990
(73) Patentinhaber: HOECHST AKTIENGESELLSCHAFT, 65926 Frankfurt am Main (DE)
(72) Erfinder: Dammel, Ralph, Dr., D-6500 Mainz-Bretzenheim (DE); Dössel, Karl-Friedrich, Dr., D-6200 Wiesbaden (DE); Lingnau, Jürgen, Dr., D-6500 Mainz-Laubenheim (DE); Theis, Jürgen, Dr., D-6000 Frankfurt/M. (DE)

(56) Entgegenhaltungen:
- EP-A- 0 164 248
- EP-A- 0 232 972
- EP-A- 0 307 752
- EP-A- 0 315 748
- V.V. ERSHOV et al.: "Studies In Organic Chemistry : Quinone Diazides", 1981, Elsevier Scientific Publishing Company, Amsterdam, NL, pp. 59-76

## Beschreibung

Die Erfindung betrifft ein negativ arbeitendes, strahlungshärtbares Gemisch, enthaltend eine Verbindung, die unter Einwirkung von hochenergetischer Strahlung eine Säure bildet sowie eine Verbindung, die durch Säure härtbar ist.

Bei der klassischen UV-Lithographie ist die Grenze der Auflösung durch die Wellenlänge der verwendeten Strahlung vorgegeben. Die stetige Verkleinerung der Dimensionen bei der Chip-Herstellung erfordert daher im Submikronbereich neue Lithographietechniken, wobei wegen ihrer extrem kurzen Wellenlänge Elektronen- oder Röntgenstrahlung eingesetzt werden. Dabei hat sich gezeigt, daß Resistmaterialien, die als Elektronenstrahlresist geeignet sind, auch als Röntgenstrahlresist eingesetzt werden können und umgekehrt.

Bekannte Resistmaterialien für diese Anwendung sind Acrylate und Methacrylate (G.M. Taylor, Solid State Technology, 124 (1984)). Bei diesen Materialien zeigte sich, daß Empfindlichkeit und Strukturauflösung meist gegenläufige Eigenschaften sind. Sollen höhere Empfindlichkeiten erreicht werden können, werden meist Halogene in den Resist eingebaut. Dabei wird in positiv arbeitenden Resists meist Fluor und Chlor, in negativ arbeitenden Resists dagegen neben Chlor eher Brom und Iod eingesetzt (T. Yamaoka et al., Phot. Sci. Eng. 23, 196 (1979)).

Im allgemeinen zeigen negativ arbeitende, also strahlungshärtbare Resists eine höhere Empfindlichkeit als positiv arbeitende, können dagegen aber nicht - wie oben ausgeführt - gleichzeitig eine hohe Auflösung im Submikronbereich aufweisen. Andererseits erreichen positiv arbeitende Resists auf Methacrylatbasis eine hohe Auflösung, sind aber mit Ausnahme der Resists auf Polymethacrylnitril-Basis nicht gegen die zur Halbleiterstrukturierung verwendeten Plasmaätzprozesse stabil. Die Methacrylatresists wiederum sind aber nicht genügend empfindlich.

Die Polymeren mit der bisher höchsten bekannten Strahlungsempfindlichkeit für Elektronen- bzw. Röntgenstrahlen sind Polyalkensulfone, insbesondere das Polybuten-1-sulfon. Der Nachteil dieser Verbindungsklasse liegt aber in ihrer weniger guten Resistenz gegenüber Plasmaätzprozessen; sie sind daher zwar für die Maskenherstellung geeignet, nicht aber für die Halbleiterfertigung mit einer Maske aus diesem Material. Es wurde daher vorgeschlagen, Polyalkensulfone mit den bekanntermaßen plasmaätzresistenten Novolakharzen zu kombinieren (M.J. Bowden et al., J. Electrochem. Soc. 128, 1304 (1981); US-A-4 289 845). Es zeigte sich aber eine starke Unverträglichkeit der beiden Polymeren miteinander, wodurch die Auflösung beeinträchtigt wird. Auch der Versuch, die Verträglichkeit durch Beimischung weiterer Komponenten zu verbessern, mußte mit einem Verlust an Empfindlichkeit erkauft werden (US-A-4 398 001).

Um hohe Empfindlichkeiten bei verbessertem Gesamteigenschaftsprofil, insbesondere verbesserter Plasmaätzbeständigkeit beizubehalten, wurden photokatalytisch arbeitende Resists entwickelt. Beispiele derartiger positiv arbeitender Systeme beschreiben u.a. die DE-A-27 18 254, 29 28 636 und die ältere deutsche Patentanmeldung DE-A-38 21 585.

Entsprechende negativ arbeitende Systeme sind z.B. Resists, die bei Bestrahlung vernetzend dimerisieren, wie Zimtsäurederivate, die polymer gebunden sind, und Polyacrylsäureester. Derartige Resists sind relativ unempfindlich. Nutzt man bei negativ arbeitenden Systemen das Prinzip der Photokatalyse, so unterscheidet man zwischen radikalisch photopolymerisierbaren Resists und Resists, bei denen aufgrund photoinduzierter Reaktionen eine Vernetzung auf kationischem Weg durch Addition, Substitution oder Kondensation erfolgt. Die ersten weisen in der Abbildungsqualität erhebliche Nachteile auf. Sie sind daher für Anwendungen im Submikrometerbereich nur bedingt geeignet.

Die Verwendung säurehärtbarer Harze in Photoresistformulierungen ist seit langem bekannt. So wird z.B. in der US-A-3,692,560 beschrieben, daß halogenhaltige Benzophenone in Verbindung mit Melaminharzen bzw. Harnstoff-Formaldehydharzen als UV-Resists eingesetzt werden können. Die DE-A-27 18 259 (=US-A-4,189,323) beschreibt die Verwendung halogenierter Derivate des s-Triazins als photolytisch aktivierbare Säurespender für positiv und negativ arbeitende Systeme, z.B. für säurehärtbare Harnstoff-Formaldehyd-, Melamin-Formaldehyd- und Phenol-Formaldehydharze (Spalte 5). Beispiele derartiger Formulierungen finden sich auch bei Vollenbroek et al, Microelectronic Engineering 6 (1987), 467.

Als photolytisch aktivierbare Säurebildner können auch Oniumsalze wie Diphenyliodoniumsalze von nicht-nukleophilen Säuren, z.B. von HSbF₆, HAsF₆ oder HPF₆, verwendet werden. Die DE-A-27 30 725 schildert die Verwendung derartiger Starter in Resistformulierungen mit Epoxiden als säurehärtbaren Materialien. Einen allgemeinen Überblick über die Verwendung von Oniumsalzen in säurehärtbaren Systemen vermittelt J.V. Crivello, Polym. Eng. Sci. 23, 953 (1983).

In der EP-A-0 164 248 werden lichthärtbare Gemische auf Basis von säurehärtbaren Harzen und Naphthochinondiaziden oder o-Nitrobenzoesäurederivaten beschrieben.

Die Verwendung halogenierter Verbindungen, wie DDT oder Gammexan, die oberhalb 299 nm praktisch nicht absorbieren, als Photoinitiatoren in säurehärtbaren Negativ-Photoresists wird in der EP-A-0 232 972 beschrieben.

Den beschriebenen Systemen ist gemeinsam, daß die Starterverbindungen nicht am eigentlichen Vernetzungsgeschehen teilnehmen und daß sie - mit Ausnahme der Oniumsalze - in wäßrig-alkalischen Entwicklern selbst nicht löslich sind. Dies führt zu drastisch reduzierten Entwicklungsgeschwindigkeiten an den Stellen, an denen der Entwickler die nicht belichtete Resistschicht abtragen soll. Die zusetzbare Menge an Starterverbindung - und damit die Empfindlichkeit des fertigen Resists - wird dadurch deutlich limitiert. Der Einsatz der Oniumsalze wie auch der in der EP-A-0 232 972 beschriebenen, als Planzenschutzmittel bekannten Initiatoren ist darüber hinaus auch aus physiologischen Gründen nicht unbedenklich.

In der nicht vorveröffentlichten EP-A 0307 752 sind Polymere mit Einheiten aus 3-mono- und/oder aus 3,5-disubstituiertem 4-Acetoxy- oder 4-Hydroxy-styrol beschrieben. Die Substituenten können Chlor- oder Bromatome sein. Daneben ist auch ein positiv arbeitendes, strahlungsempfindliches Gemisch beschrieben, das neben den genannten Polymeren noch ein ortho-Chinondiazid umfaßt. Enthält das Gemisch zusätzlich noch eine Verbindung, die unter der Einwirkung der beim Bestrahlen des ortho-Chinondiazids freigesetzten Säure eine Vernetzung ("Härtung) bewirkt, so lassen sich aus dem normalerweise positiv arbeitenden Gemisch auch negative Bilder herstellen.

Es bestand daher die Aufgabe, ein negativ arbeitendes Resistsystem für die Aufzeichnung energiereicher Strahlung vorzuschlagen, das sich bei Tages- und Kunstlicht im wesentlichen ohne besondere Vorsichtsmaßnahmen verarbeiten läßt, jedoch gegenüber energiereicher Strahlung, insbesondere Elektronen- und Röntgenstrahlung, hochempfindlich ist und nach Entwicklung mit wäßrig-alkalischen Entwicklern Resiststrukturen hoher Auflösung ergibt, das physiologisch unbedenklich ist und eine gute Resistenz gegenüber flüssigen und Plasmaätzmedien aufweist.

Erfindungsgemäß wird ein durch hochenergetische Strahlung härtbares Gemisch vorgeschlagen, das eine Verbindung, die unter Einwirkung von hochenergetischer Strahlung eine Säure bildet, sowie eine Substanz enthält, die durch Säure härtbar ist.

Das erfindungsgemäße Gemisch ist dadurch gekennzeichnet, daß die Verbindung, die eine Säure bildet, aromatisch gebundenes Chlor oder Brom enthält und einen pKₐ-Wert unterhalb 12 aufweist.

Es war überraschend, daß durch die Verwendung derartiger Starter auch säurehärtbare Gemische besonders hoher Empfindlichkeit erhalten werden, ohne daß wegen der erforderlichen hohen Starterkonzentrationen das Entwicklungsverhalten oder die thermische Stabilität der erhaltenen Resiststrukturen negativ beeinflußt werden, wie dies bei Verwendung der in der EP-A-0 232 972 beschriebenen Starter der Fall ist. Dies wird darauf zurückgeführt, daß aufgrund der Starterstruktur die Alkalilöslichkeit der nicht belichteten Resistbereiche deutlich erhöht wird. An den belichteten Stellen des Resists nimmt hingegen der Starter je nach seiner Struktur ebenfalls an der Vernetzungsreaktion teil.

Von den säurebildenden Startern, die aromatisch gebundenes Chlor oder Brom enthalten, werden solche bevorzugt, die einen pKₐ-Wert im Bereich von 6 bis 10 aufweisen.

Der pKₐ-Wert von chemischen Verbindungen läßt sich nach herkömmlichen Methoden bestimmen, es ist aber auch eine theoretische Berechnung, z.B. mit dem Programm "CAMEO", möglich.

Die säurebildende Starter entsprechen der allgemeinen Formel I 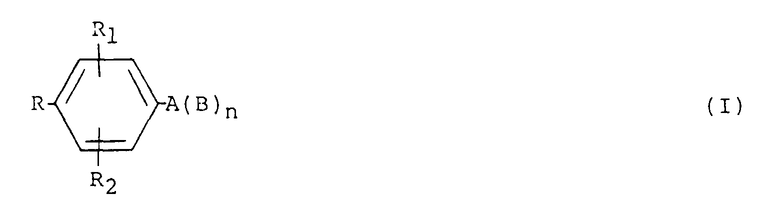 mit mindestens einem aromatisch gebundenen Chlor- oder Bromatom, wobei
- R: OH oder COOH ist,
- R₁ und R₂: gleich oder verschieden sind und Wasserstoff, Chlor, Brom, Alkyl, ggf. substituiert durch Aryl-, Alkoxy-, Aryloxy-, Hydroxygruppen oder Fluoratome; oder Aryl, ggf. substituiert durch Alkoxy-, Aryloxy-, Hydroxygruppen oder Halogenatome,
- und n: 0 bis 3 bedeutet, wobei
für n = 0:
A Wasserstoff, Chlor, Brom, Alkyl, ggf. substituiert durch Alkoxy-, Aryloxy-, Hydroxy-, Arylreste oder Fluoratome; Aryl, ggf. substituiert durch Alkoxy-, Aryloxy-, Hydroxy-, Carboxylreste oder Halogenatome, für n = 1:
A eine Einfachbindung, -O-, -S-, -SO₂-, -NH-, -NR₃-, Alkylen, Perfluoralkylen, für n = 2:
A 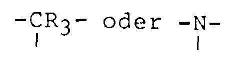 und für n = 3:
A 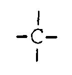 bedeutet, sowie
- B: 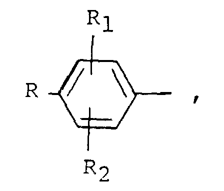 Carboxyl, substituiertes Carbonyl, insbesondere Alkyl- oder Arylcarbonyl, Carboxyalkyl sowie substituiertes Sulfonylimidocarbonyl und
- R₃: Alkyl, insbesondere (C₁-C₃)Alkyl, oder Aryl, insbesondere Phenyl,
bedeutet.

Ganz besonders bevorzugt werden Verbindungen, in denen
- R₁ und R₂: gleich sind und insbesondere Chlor oder Brom bedeuten, wobei sie jeweils in ortho-Position zu R stehen, sowie
- R: eine Hydroxygruppe bedeutet.

Dabei werden ebenso solche Verbindungen bevorzugt, in denen
- A: (für n=1 und B gleich 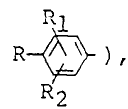 -SO₂-, Propylen oder Perfluorpropylen, in den beiden letzten Fällen vorzugsweise Propyliden oder Perfluorpropyliden ist,
oder
- A: (für n=1 und B gleich Alkylcarbonyl, insbesondere Methylcarbonyl, Carboxyalkyl, insbesondere Carboxymethyl oder substituiertes Sulfonylimidocarbonyl, insbesondere p-Toluolsulfonylimidocarbonyl) -O-, -NH- oder -NR₃- oder
- A: (für n=O) Hydroxyl, Carboxyl oder Alkyl, welches an jedem zweiten C-Atom durch Phenyl, chloriertes oder bromiertes Phenyl substituiert ist,
bedeutet.

Insbesondere bevorzugt sind Verbindungen, in denen für n=0 und A gleich substituiertes Carbonyl:
- R: Hydroxyl und
- R₁ und R₂: jeweils in ortho-Position zu R stehend Chlor oder Brom bedeuten, oder
für n=0 und A gleich ggf. substituiertes Alkyl:
- R: Hydroxyl und
- R₁ und R₂: jeweils in ortho-Position zu R stehend Wasserstoff, Chlor oder Brom bedeuten.

Der Gehalt an säurebildenden Startern in dem erfindungsgemäßen strahlungsempfindlichen Gemisch liegt im allgemeinen bei 2 bis 50 Gew.-%, vorzugsweise bei 4 bis 25 Gew.-%, jeweils bezogen auf das Gesamtgewicht der Schicht.

Als durch Säure katalytisch härtbare Systeme kommen vernetzbare Systeme in Frage, bei denen die Vernetzerkomponente und die mit ihr reagierende vernetzbare funktionelle Gruppe in ein und demselben Molekül, bevorzugt einem Oligomer- oder Polymermolekül, enthalten sind. Beispiele sind Copolymere des N-Alkoxymethyl-methacrylamids mit z.B. Acrylsäure oder Brenzkatechinmonomethacrylat, ggf. in Gegenwart weiterer Comonomerer, wie sie in der EP-A-0 184 044 beschrieben sind.

Als säurehärtbare Komponenten kommen ferner Verbindungen in Betracht, die kationisch polymerisierbare Gruppierungen enthalten. Zu nennen sind Vinylether, Epoxide, u.ä. Eine Übersicht vermittelt Makromol. Chemie, Macromolecular Symposia, Bd. 13/14, München 1988. Bevorzugt werden solche Verbindungen eingesetzt, in denen die genannten Gruppierungen mehrfach enthalten sind.

Ferner sind als säurehärtbare Komponenten Verbindungen geeignet, die durch Säure katalysiert mit sich selbst oder mit dem Bindemittel Kondensationsreaktionen eingehen. Zu nennen sind hier Melamin-Formaldehyd-Harze, Benzoguanamin-Formaldehydharze, Glycoluril-Formaldehyd-Harze, Harnstoff-Formaldehyd-Harze, aber auch hydroxymethylierte Phenole und Kresole, wie sie z.B. in der EP-A-0 212 482 beschrieben werden.

Bevorzugt werden Gemische, bei denen die reagierenden Gruppen auf verschiedene Moleküle verteilt sind. In einem derartigen Fall enthält das Bindemittel eine vernetzbare funktionelle Gruppe. Als solche kommen -SH, -OH, -CONH₂ sowie -COOH-Gruppen in Frage. Ferner eignen sich Gemische, die durch Kondensation mit Formaldehyd in Gegenwart von Säure gehärtet werden können. Hierzu zählen insbesondere entsprechend substituierte Phenolharze. Anstelle von Formaldehyd können auch Verbindungen eingesetzt werden, die Formaldehyd freisetzen, z.B. Trioxan. Diese werden bevorzugt in Kombination mit Phenolharzen verwendet.

Die in dem erfindungsgemäßen Gemisch eingesetzten Bindemittel sind in Wasser unlöslich, in wäßrig-alkalischen Medien und in organischen Lösungsmitteln hingegen löslich. Dies wird erreicht durch den Einbau funktioneller Gruppen, deren pKₐ unterhalb 12, bevorzugt zwischen 6 und 10 liegt. Typische Beispiele sind Phenole, Carbonsäuren, aber auch Sulfonamide und Imide.

Bevorzugt eingesetzt werden Phenolharze vom Novolak-Typ, z.B. Phenol-Formaldehydharze, Kresol-Formaldehydharze, deren Mischkondensate und deren Mischungen, sowie Phenol- und Kresol-Kondensate mit anderen Aldehyden.

Darüber hinaus können aber auch eingesetzt werden:

Polymere von Styrol mit Einheiten von Alkenylsulfonylaminocarbonyloxy- oder Cycloalkenylsulfonyl-aminocarbonyloxy- (EP-A-0 184 804), Polymere der Acryl-, Methacryl-, Malein-, Itaconsäure etc., ggf. mit seitenständigen, vernetzenden -CH₂OR-Gruppen (EP-A-0 184 044), Polymerisate aus Vinylmonomeren mit Alkenylphenoleinheiten (EP-A-0 153 682), Polyvinylphenole (DE-C-23 22 230), polymere Bindemittel mit seitenständigen, phenolischen Hydroxylgruppen (EP-A-0 212 439 und 0 212 440), Styrol-Maleinsäureanhydrid-Mischpolymerisate (DE-A-31 30 987), Polymere aus ungesättigten (Thio)phospinsäureiso(thio)cyanaten mit einem aktiven Wasserstoff enthaltenden Polymeren (DE-A 36 15 612 und 36 15 613), Polymere mit Vinylacetat-, Vinylalkohol- und Vinylacetaleinheiten (EP-A-0 216 083) sowie Polyvinylacetale mit Einheiten aus Hydroxyaldehyden (DE-A-36 44 162).

Zur Verbesserung der Gesamteigenschaften können auch Gemische aus mehreren der genannten Bindemittel eingesetzt werden.

Die Menge des Bindemittels beträgt im allgemeinen 1 bis 90, insbesondere 5 bis 90 Gew.-%, vorzugsweise 50 bis 90 Gew.-%, bezogen auf das Gesamtgewicht der strahlungsempfindichen Mischung.

Den erfindungsgemäßen strahlungsempfindlichen Gemischen können ggf. Farbstoffe, Pigmente, Weichmacher, Netzmittel und Verlaufmittel, aber auch Polyglykole, Celluloseether, z.B. Ethylcellulose, zur Verbesserung spezieller Erfordernisse wie Flexibilität, Haftung und Glanz zugesetzt werden.

Vorzugsweise wird das erfindungsgemäße strahlungsempfindliche Gemisch in Lösungsmitteln wie Ethylenglykol, Glykolethern wie Glykolmonomethylether, Glykoldimethylether, Glykolmonoethylether oder Propylenglykolmonoalkylethern, insbesondere Propylenglykolmethylether; aliphatischen Estern wie Ethylacetat, Hydroxyethylacetat, Alkoxyethylacetat, n-Butylacetat, Propylenglykolmonoalkyletheracetat, insbesondere Propylenglykolmethyletheracetat oder Amylacetat; Ethern wie Dioxan, Ketonen wie Methylethylketon, Methyl-isobutylketon, Cyclopentanon und Cyclohexanon; Dimethylformamid, Dimethylacetamid, Hexamethylphosphorsäureamid, N-Methyl-pyrrolidon, Butyrolacton, Tetrahydrofuran und in Mischungen derselben gelöst. Besonders bevorzugt werden Glykolether, aliphatische Ester sowie Ketone.

Die mit den Bestandteilen des strahlungsempfindlichen Gemisches entstehenden Lösungen haben in der Regel einen Feststoffgehalt von 5 bis 60 Gew.-%, vorzugsweise bis 50 Gew.-%.

Erfindungsgemäß wird ferner ein strahlungsempfindliches Aufzeichnungsmaterial beansprucht, im wesentlichen bestehend aus einem Schichtträger und dem darauf aufgetragenen strahlungsempfindlichen Gemisch.

Als Schichtträger kommen alle Materialien in Frage, aus denen Kondensatoren, Halbleiter, mehrlagige gedruckte Schaltungen oder integrierte Schaltkreise bestehen bzw. hergestellt werden können. Insbesondere sind Oberflächen aus reinem, thermisch oxydiertem und/oder mit Aluminium beschichtetem Silicium zu nennen, die gegebenfalls auch dotiert sein können, einschließlich aller anderen in der Halbleitertechnologie üblichen Träger bzw. Substrate wie Siliciumnitrid, Galliumarsenid, Indiumphosphid. Weiterhin kommen in Frage die aus der Flüssigkristalldisplay-Herstellung bekannten Substrate wie Glas, Indium-Zinnoxid; ferner Metallplatten und -folien, beispielsweise aus Aluminium, Kupfer, Zink; Bimetall- und Trimetallfolien, aber auch elektrisch nicht leitende Folien, die mit Metallen bedampft sind, ggf. mit Aluminium beschichtete SiO₂-Materialien und Papier. Diese Substrate können einer Vorbehandlung durch Erwärmen unterzogen werden, oberflächlich angerauht, angeätzt oder zur Verbesserung erwünschter Eigenschaften, z. B. der Erhöhung der Hydrophilie, mit Chemikalien behandelt sein.

In einer besonderen Ausführungsform kann das strahlungsempfindliche Gemisch zur besseren Haftung in dem Resist oder zwischen dem Resist und dem Träger bzw. Substrat einen Haftvermittler enthalten. Bei Silicium- bzw. Siliciumdioxid-Substraten kommen hierfür Haftvermittler vom Aminosilan-Typ, z.B. 3-Aminopropyl-triethoxysilan oder Hexamethyl-disilazan, in Frage.

Beispiele für Träger, die zur Herstellung von Druckplatten für den Hochdruck, den Flachdruck, den Siebdruck, den Tiefdruck sowie von Reliefkopien Verwendung finden können, sind Aluminiumplatten, ggf. anodisch oxydierte, aufgerauhte und/oder silikatisierte Aluminiumplatten: Zinkplatten, Stahlplatten, die ggf. verchromt wurden, sowie Kunststoffolien oder Papier.

Bestrahlt wird das erfindungsgemäße Aufzeichnungsmaterial bildmäßig mit hochenergetischen Strahlungsquellen; bevorzugt ist Elektronen- oder Röntgenstrahlung. Bei Verwendung hinreichend transparenter Bindemittel ist auch eine bildmäßige Bestrahlung mit kurzwelliger UV-Strahlung (deep UV) möglich.

Die Schichtstärke variiert in Abhängigkeit von ihrem Einsatzgebiet. Sie beträgt etwa 0,1 bis 1000, insbesondere 1 bis 10 µm.

Das Auftragen des strahlungsempfindlichen Gemisches auf den Träger kann durch Aufsprühen, Fließbeschichten, Walzen, Schleuderbeschichten und Tauchbeschichten erfolgen. Danach wird das Lösemittel durch Verdampfen entfernt, so daß auf der Oberfläche des Trägers die strahlungsempfindliche Schicht zurückbleibt. Die Entfernung des Lösemittels kann gegebenfalls durch Erhitzen der Schicht auf Temperaturen bis zu 150° C gefördert werden. Das Gemisch kann aber auch zunächst auf obengenannte Weise auf einen Zwischenträger aufgetragen werden, von dem aus es unter Druck und erhöhter Temperatur auf das endgültige Trägermaterial übertragen wird. Als Zwischenträger können grundsätzlich alle auch als Trägermaterialien ausgewiesenen Materialien Anwendung finden, soweit sie flexibel sind. Anschließend wird die Schicht bildmäßig bestrahlt. Bevorzugt wird energiereiche Strahlung wie Röntgen- oder Elektronenstrahlung. Besonders bevorzugt wird energiereiche Synchrotronstrahlung mit Dosiswerten von 20 bis 200 mJ/cm² oder Strahlung eines Elektronenstrahlschreibers. Die eigentliche Differenzierungsreaktion (Vernetzung) kann in einzelnen Fällen bei Raumtemperatur erfolgen. In der Regel ist aber ein Nacherhitzen (post-exposure-bake) günstig, das etwa 1 bis 30 Minuten dauern und vorzugsweise bei Temperaturen von etwa 90 bis 150° C erfolgen kann. In der strahlungsempfindlichen Schicht wird anschließend durch Entwicklung ein Bildmuster freigelegt, indem die Schicht mit einer Entwicklerlösung behandelt wird, die die nicht bestrahlten Bereiche des Materials löst bzw. entfernt.

Als Entwickler werden Lösungen von alkalischen Reagenzien wie Silikaten, Metasilikaten, Hydroxiden, Hydrogen-bzw. Dihydrogenphosphaten, Carbonaten bzw. Hydrogencarbonaten, insbesondere von Alkali- oder Ammoniumionen, aber auch von Ammoniak oder organischen Ammoniumbasen und dergleichen verwendet. Der Gehalt dieser Substanzen in der Entwicklerlösung beträgt im allgemeinen 0,1 bis 15 Gew.-%, vorzugsweise 0,5 bis 5 Gew.-%, bezogen auf das Gewicht der Entwicklerlösung.

Anhand der folgenden Beispiele soll die Herstellung der im erfindungsgemäßen strahlungsempfindlichen Gemisch enthaltenen und zum Teil neuen, aromatisches Chlor oder Brom enthaltenden Verbindungen verdeutlicht werden. Die Mengen sind zumeist in Gewichtsteilen (Gt) angegeben, Mengenverhältnisse und Prozentangaben sind, wenn nichts anderes angegeben ist, in Gewichtseinheiten zu verstehen.

### Beispiel 1

Es wurde eine Beschichtungslösung hergestellt aus:
- 17 Gt: eines Kresol-Formaldehyd-Novolaks mit einem Erweichungsbereich von 105-120° C,
- 4 Gt: Tetrabrom-Bisphenol A,
- 5 Gt: Poly(alkoxymethyl)melamin; Alkoxygruppen gemischt aus C₁ und höheren (Cymel 1116; Cyanamid) und
- 74 Gt: Propylenqlykolmethyletheracetat (PGMEA)

Die Lösung wurde auf einen mit einem Haftvermittler (Hexamethyldisilazan) behandelten Siliciumwafer bei 5.000 U/min aufgeschleudert. Nach 3 Minuten Trocknen bei 95° C im Umluftofen wurde eine Schichtdicke von 1,0 µm erhalten. Bildmäßig bestrahlt wurde mit Synchrotonstrahlung (BESSY, Berlin, 2 mm Luftspalt) einer Dosis von 200 mJ/cm² durch eine Gold-auf-Silicium-Maske. Den experimentellen Aufbau findet man bei A. Heuberger, "X-Ray Lithography", Microelectronic Engineering 3, 535-556 (1985). Nach der Belichtung wurde der Wafer 10 Minuten auf 100° C im Umluftofen erwärmt und anschließend in einer Lösung von
- 1 %: NaOH,
- 0,4 %: Alkylaryldisulfonsäure (Natriumsalz) und
- 0,1 %: kationenaktivem Netzmittel (heterocyclische quaternäre Ammoniumbase) in
- 98,5 %: vollentsalztem Wasser
innerhalb von 60 s entwickelt.

Man erhielt ein fehlerfreies Bild mit allen Details der Maske, wobei auch Linien und Gräben von 0,3 µm fehlerfrei wiedergegeben wurden. Die Resistflanken waren nicht negativ unterhöhlt und zeigten in einer Aufnahme im Rasterelektronenmikroskop Winkel von nahezu 90°.

### Beispiel 2

Es wurde eine Beschichtungslösung hergestellt aus
- 15 Gt: des in Beispiel 1 angegebenen Novolaks,
- 8,5 Gt: 1,1,1-Tris-(3,5-dibrom-4-hydroxy-phenyl)ethan,
- 5 Gt: Cymel 1116,
- 71,5 Gt: PGMEA.

Die Lösung wurde wie in Beispiel 1 aufgeschleudert. Nach dem Trocknen auf einer erwärmten Platte (hot plate; 110° C, 1 Minute) wurde mit 90 mJ/cm² wie in Beispiel 1 bestrahlt. Nach 2 Minuten Nacherwärmen (post exposure bake) auf 110° C wurde mit einer Lösung von
- 2,65 %: Natriummetasilikat x 9 H₂O
- 1,7 %: Trinatriumphosphat x 12 H₂O und
- 0,15 %: Natriumdihydrogenphosphat in
- 95,5 %: vollentsalztem Wasser
150 s entwickelt. Die erhaltenen Strukturen entsprachen denen aus Beispiel 1.

### Herstellung von 1,1,1-Tris-(3,5-dibrom-4-hydroxy-phenyl)ethan

102 g Tris-(4-hydroxyphenyl)ethan wurden in einer Mischung aus 500 ml Eisessig und 250 ml Wasser suspendiert. Bei 10° C wurden anschließend in die gerührte Suspension 334 g Brom zugetropft. Nach erfolgter Abreaktion des Broms wurden 750 ml Wasser zugegeben und die ausgefallenen Kristalle über eine Nutsche abgesaugt. Sie wurden mit Wasser gewaschen, aus Toluol umkristallisiert und anschließend getrocknet. Das Produkt hatte einen Schmelzpunkt von 276-278° C. Das NMR-Spektrum (CDCl₃) zeigte folgende Signale: CH₃:δ=2,05 (3H)s; OH: δ=5,89 (3H)s; Phenyl: δ =7,1 (6H)s.

### Beispiel 3

Es wurde verfahren wie in Beispiel 2, mit dem Unterschied, daß anstelle von Cymel 1116 das Melaminharz Maprenal 900 (Cassella AG) eingesetzt wurde, das ein ähnliches Polyalkoxymethylmelamin mit C₁- und n-C₄-Alkoxygruppen ist. Die Entwicklungsdauer betrug in dem gleichen Entwickler wie in Beispiel 2 20 s.

### Beispiel 4

Es wurde eine Beschichtungslösung hergestellt aus
- 20 Gt: des Novolaks aus Beispiel 1,
- 3,4 Gt: Tetrachlorbisphenol A,
- 5,1 Gt: Cymel 1116,
- 71,5 Gt: Cyclohexanon.

Nach Aufschleudern auf einen Si-Wafer bei 5.000 U/min wurde 1 Minute bei 110° C getrocknet, dann mit 30 mJ/cm² bildmäßig bestrahlt, danach 3 Minuten bei 105° C getempert und schließlich innerhalb von 165 s in einer Lösung von
- 5,3 %: Natriummetasilikat x 9 H₂O,
- 3,4 %: Trinatriumphosphat x 12 H₂O und
- 0,3 %: Natriumdihydrogenphosphat in
- 91 %: vollentsalztem Wasser
entwickelt.

### Beispiel 5

Reduziert man den Anteil an Tetrachlorbisphenol A in Beispiel 4 auf 0,6 Gt, so wird bei sonst gleicher Vorgehensweise eine Entwicklungsdauer von 420 s benötigt.

### Beispiel 6

Es wurde eine Beschichtungslösung hergestellt aus
- 20 Gt: Novolak gemäß Beispiel 1,
- 5,1 Gt: Neopentyl-diglycidylether und
- 8,5 Gt: Tetrabrom-Bisphenol A in
- 71,4 Gt: PGMEA

Die Schicht wurde 1 Minute bei 110° C getrocknet. Nach einer Bestrahlung mit 200 mJ/cm² wurde 3 Minuten auf 120° C nacherhitzt. Die Entwicklung in dem in Beispiel 4 angegebenen Entwickler dauerte 60 s.

### Beispiel 7

Es wurde eine Beschichtungslösung hergestellt aus
- 22,7 Gt: eines Copolymeren aus 84 Gew.-% Brenzkatechinmonomethacrylat und 16 Gew.-% N-Methoxymethylmethacrylamid und
- 5,7 Gt: Tetrabrombisphenol A in
- 71,6 Gt: PGMEA

Die Schicht wurde 1 Minute bei 110° C getrocknet. Nach Bestrahlung mit 200 mJ/cm² und 3 Minuten Nacherhitzen auf 130° C wurde in dem in Beispiel 4 angegebenen Entwickler innerhalb von 30 s entwickelt.

### Beispiel 8 (Vergleichsbeispiel)

Es wurde eine Beschichtungslösung hergestellt aus
- 20 Gt: des Novolaks aus Beispiel 1,
- 3,4 Gt: DDT und
- 5,1 Gt: Cymel 1116 in
- 71,5 Gt: PGMEA

Dies entspricht einer Formulierung analog Beispiel 4, jedoch mit dem bekannten nicht alkalilöslichen Starter DDT. Es wurde 1 Minute bei 110° C getrocknet. Die Bestrahlung mit 30 mJ/cm² und anschließende Nacherwärmung von 3 Minuten bei 105° C lieferte einen Resistfilm, der an den nichtbelichteten Stellen selbst nach 30 Minuten in dem in Beispiel 4 angegebenen Entwickler nicht entwickelt werden konnte.

### Beispiel 9 (Vergleichsbeispiel)

Wird der Anteil des DDT analog Beispiel 5 auf 0,6 Gt reduziert, so ist eine Entwicklung mit dem Entwickler in Beispiel 4 möglich, sie dauert aber verglichen mit Beispiel 5 erheblich länger (18 Minuten).

## Patentansprüche

1. Negativ arbeitendes strahlungsempfindliches Gemisch, enthaltend eine Verbindung, die unter der Einwirkung von kurzwelliger UV-Strahlung, Röntgen- oder Elektronenstrahlung eine Säure bildet, sowie eine Substanz, die durch Säure härtbar ist, dadurch gekennzeichnet, daß die säurebildende Verbindung einen pKₐ-Wert unterhalb 12 aufweist und der allgemeinen Formel I 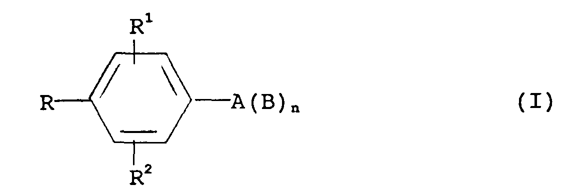 mit mindestens einem aromatisch gebundenen Chlor- oder Bromatom entspricht, wobei
R OH oder COOH ist,
R¹ and R² gleich oder verschieden sind und Wasserstoff, Chlor, Brom, Alkyl, ggf. substituiert durch Aryl-, Alkoxy-, Aryloxy-, Hydroxygruppen oder durch Fluoratome; oder Aryl, ggf. substituiert durch Alkoxy-, Aryloxy-, Hydroxygruppen oder Halogenatome, und
n 0 bis 3 bedeutet, wobei
für n = 0:
A Wasserstoff, Chlor, Brom, Alkyl, ggf. substituiert durch Alkoxy-, Aryloxy-, Hydroxy-, Arylreste oder Fluoratome; Aryl, ggf. substituiert durch Alkoxy-, Aryloxy-, Hydroxy-, Carboxylreste oder Halogenatome,
für n = 1:
A eine Einfachbindung, -O-, -S-, -SO₂-, -NH-, -NR₃-, Alkylen, Perfluoralkylen,
für n = 2:
A 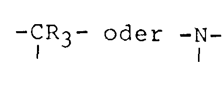 und
für n = 3:
A 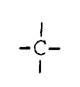 bedeutet,
sowie
B 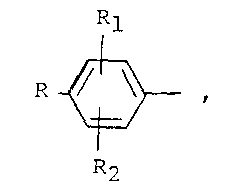 Carboxyl, substituiertes Carbonyl, insbesondere Alkyl- oder Arylcarbonyl, Carboxyalkyl sowie substituiertes Sulfonylimidocarbonyl und
R₃ Alkyl, insbesondere (C₁-C₃)Alkyl, oder Aryl, insbesondere Phenyl,
bedeutet.

2. Strahlungseinpfindliches Gemisch nach Anspruch 1, dadurch gekennzeichnet, daß die säurebildende Verbindung einen pKₐ Wert von 6 bis 10 aufweist.

3. Strahlungsempfindliches Gemisch nach Anspruch 1, dadurch gekennzeichnet, daß das Gemisch ein in Wasser unlösliches, in wäßrigem Alkali lösliches Bindemittel enthält.

4. Strahlungsempfindliches Aufzeichnungsmaterial für kurzwellige UV-Strahlung, Röntgen- oder Elektronenstrahlung, im wesentlichen bestehend aus einem Träger und einer strahlungsempfindlichen Schicht, dadurch gekennzeichnet, daß die Schicht aus einem negativ arbeitenden, strahlungsempfindlichen Gemisch gemäß einem der Ansprüche 1 bis 3 besteht.

5. Verfahren zur Aufzeichnung von kurzwelliger UV-Strahlung, Röntgen- oder Elektronenstrahlung mittels eines strahlungsempfindlichen Aufzeichnungsmaterials, dadurch gekennzeichnet, daß ein negativ arbeitendes, strahlungsempfindliches Gemisch gemäß den Ansprüchen 1 bis 3 auf einen ggf. mit einem Haftvermittler beaufschlagten Träger aufgebracht wird, das Material getrocknet, anschließend mit Strahlung der genannten Art, insbesondere Röntgen- oder Elektronenstrahlung, bildmäßig bestrahlt, danach ggf. bei erhöhter Temperatur getempert und abschließend das Bild durch Entfernen der unbestrahlten Schichtbereiche mit einem wäßrig-alkalischen Entwickler entwickelt wird.

## Claims

1. Negative-working radiation-sensitive composition comprising a compound which forms an acid when exposed to deep UV radiation, X-ray or electron beam, and an acid-curable substance, characterized in that the acid-forming compound has a pKₐ value of less than 12 and corresponds to the general formula I 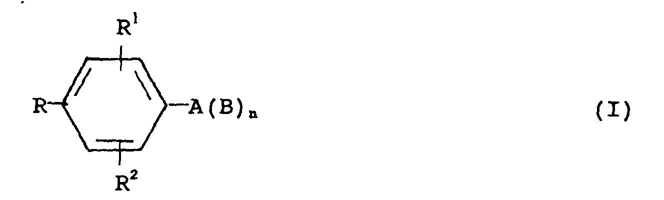 containing at least one aromatically bound chlorine or bromine atom, in which formula
R denotes OH or COOH,
R¹ and R² are identical or different and denote hydrogen, chlorine, bromine, alkyl, optionally substituted by aryl, alkoxy, aryloxy or hydroxyl groups or by fluorine atoms; or aryl, optionally substituted by alkoxy, aryloxy or hydroxyl groups or by halogen atoms,
n denotes an integer from 0 to 3, whereby if n = 0:
A denotes hydrogen, chlorine, bromine, alkyl, optionally substituted by alkoxy, aryloxy, hydroxyl or aryl groups or by fluorine atoms; aryl, optionally substituted by alkoxy, aryloxy, hydroxyl or carboxyl groups or by halogen atoms;
if n = 1:
A denotes a single bond, -O-, -S-, -SO₂-, -NH-,-NR₃-, alkylene or perfluoroalkylene;
if n = 2:
A denotes 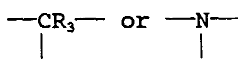 and
if n = 3:
A denotes 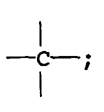
and
B denotes 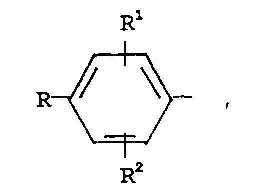 carboxyl, substituted carbonyl, in particular alkylcarbonyl or arylcarbonyl, carboxyalkyl or substituted sulfonylimidocarbonyl, and
R³ denotes alkyl, in particular (C₁-C₃)alkyl, or aryl, in particular phenyl.

2. Radiation-sensitive composition as claimed in claim 1, characterized in that the acid-forming compound has a pKₐ value of 6 to 10.

3. Radiation-sensitive composition as claimed in claim 1, characterized in that it contains a binder that is insoluble in water and soluble in aqueous alkali.

4. Radiation-sensitive recording material for use with deep UV radiation, X-ray or electron beam, essentially comprising a support and a radiation-sensitive layer, characterized in that the layer comprises a negative-working radiation-sensitive composition as claimed in any of claims 1 to 3.

5. A process for recording deep UV radiation, X-ray or electron beam by means of a radiation-sensitive recording material, characterized in that a negative-working radiation-sensitive composition as claimed in any of claims 1 to 3 is applied to a support which may have been provided with an adhesion promoter, the material is dried, then imagewise irradiated with radiation of said type, in particular with X-ray or electron beam, thereafter optionally baked at elevated temperature, and finally the non-irradiated areas of the layer are removed using an aqueous-alkaline developer to produce the image.

## Revendications

1. Composition sensible aux radiations, travaillant en négatif, contenant un composé qui forme un acide sous l'effet d'un rayonnement UV à courte longueur d'onde, de rayons X ou d'un faisceau d'électrons, ainsi qu'une substance qui est durcissable par un acide, caractérisée en ce que le composé générateur d'acide présente un pKₐ inférieur à 12, correspond à la formule générale I 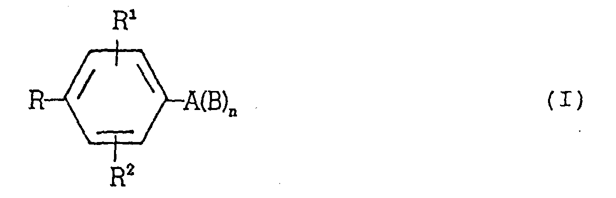 et contient au moins un atome de chlore ou de brome lié au noyau aromatique,
formule dans laquelle
R est OH ou COOH,
R₁ et R₂ sont identiques ou différents et représentent un atome d'hydrogène, de chlore ou de brome, ou un radical alkyle éventuellement substitué par des atomes de fluor ou par des groupes aryle, alcoxy, aryloxy, hydroxy; ou un radical aryle éventuellement substitué par des atomes d'halogène ou par des groupes alcoxy, aryloxy, hydroxy,
n va de 0 à 3,
pour n = 0:
A représentant un atome d'hydrogène, de chlore ou de brome, ou un radical alkyle éventuellement substitué par des atomes de fluor ou par des groupes alcoxy, aryloxy, hydroxy, aryle; un radical aryle éventuellement substitué par des atomes d'halogène ou par des groupes alcoxy, aryloxy, hydroxy, carboxy,
pour n = 1:
A représentant une liaison simple, -O-, -S-, -SO₂-, -NH-, -NR₃- ou un groupe alkylène ou perfluoroalkylène,
pour n = 2:
A représentant 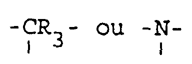 et
pour n = 3:
A représentant 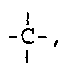 et
B représente 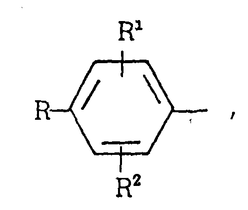 le groupe carboxy, un groupe carbonyle substitué, en particulier alkyl- ou arylcarbonyle, un groupe carboxyalkyle ainsi qu'un groupe sulfonylimidocarbonyle substitué, et
R₃ représente un groupe alkyle, en particulier alkyle en C₁-C₃, ou aryle, en particulier le groupe phényle.

2. Composition sensible aux radiations selon la revendication 1, caractérisée en ce que le composé générateur d'acide présente un pKₐ de 6 à 10.

3. Composition sensible aux radiations selon la revendication 1, caractérisée en ce que la composition contient un liant insoluble dans l'eau, soluble dans une solution aqueuse-alcaline.

4. Matériau de reproduction sensible aux radiations par rayonnement UV à courte longueur d'onde, rayons X ou faisceau d'électrons, essentiellement constitué d'un support et d'une couche sensible aux radiations, caractérisé en ce que la couche est constituée d'une composition sensible aux radiations, travaillant en négatif, selon l'une des revendications 1 à 3.

5. Procédé pour l'enregistrement d'un rayonnement UV à courte longueur d'onde, de rayons X ou d'un faisceau d'électrons au moyen d'un matériau de reprographie sensible aux radiations, caractérisé en ce que l'on applique sur un support, éventuellement revêtu d'un agent favorisant l'adhérence, une composition sensible aux radiations, travaillant en négatif, selon les revendications 1 à 3, on sèche le matériau, puis on l'irradie selon l'image avec un rayonnement du type cité, en particulier des rayons X ou un faisceau d'électrons, et ensuite on le soumet éventuellement à un traitement thermique à haute température puis on développe l'image par élimination des zones non irradiées de la couche, avec un révélateur aqueux-alcalin.
